Europäisches Patentamt

European Patent Office

Office européen des brevets

(1) Publication number: **0 191 180**
**B1**

(12) **EUROPEAN PATENT SPECIFICATION**

(45) Date of publication of patent specification: **21.03.90**

(51) Int. Cl.⁵: **G 01 R 33/30,** G 01 R 33/36

(21) Application number: **85115797.4**

(22) Date of filing: **11.12.85**

(54) Device for imaging of forked body regions using magnetic resonance.

(30) Priority: **28.12.84 US 687109**

(43) Date of publication of application:
**20.08.86 Bulletin 86/34**

(45) Publication of the grant of the patent:
**21.03.90 Bulletin 90/12**

(84) Designated Contracting States:
**DE FR GB NL**

(56) References cited:
**EP-A-0 107 238**
**EP-A-0 135 326**
**WO-A-84/00214**
**DE-A-3 323 657**
**US-A-4 411 270**

**ELECTRO MEDICA, vol. 52, no. 1, January 1984,
pages 28-37, Erlangen, DE; A. GANSSEN:
"Bericht über die Tagungen der Society of
Magnetic Resonance in Medicine vom 16. bis
19.8.1983 in San Francisco und der International
Society of Magnetic Resonance vom 22. bis
26.8.1983 in Chicago**

(73) Proprietor: **Siemens Aktiengesellschaft
Wittelsbacherplatz 2
D-8000 München 2 (DE)**

(72) Inventor: **Starewicz, Piotr. M.
40 Egerton Road
Arlington Massachusetts 02174 (US)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention relates to devices used in magnetic resonance imaging. More particularly, the invention relates to devices used to examine parts of ·the human body forming an angle therebetween, such as the pelvis or armpit. These parts of the body are called "forked body region" in the following disclosure.

To image a forked body region such as the pelvis using magnetic resonance techniques, the region is conventionally placed inside a whole-body coil or resonator. To do this, the patient is drawn into a magnet so that the pelvis can be developed within the magnetic field. Because a body coil must have a large diameter, its filling factor in the case of e.g. a pelvis is relatively poor. This causes low signal to noise ratios and as a result high resolution images cannot be produced within a reasonable time. This in turn means that the patient must remain in e.g. the whole-body coil for a prolonged period, which is disturbing to the patient.

One object of the present invention is to provide a device that facilitates magnetic resonance imaging of forked body regions such as the pelvis by providing a higher filling factor.

Another object is to provide such a device which minimizes examination time and also improves the signal to noise ratio and resolution of the image.

Yet another object is to facilitate e.g. pelvic examinations by providing a device which is easy to use.

Yet another object is to provide such a device which is cost-effective to produce. The invention is as defined in Claim 1.

The first and second regions are spaced such that a forked body region under examination may fit between them, with the third region inserted into the fork of the body part examined. In the case of a pelvic examination, the first and second regions would be placed above and below the patient's groin area and the third region would be located between the patient's legs in the crotch area.

In a particular embodiment, elements such as tuning capacitors are connected to the conductor at the third region thereof.

The invention will be better understood with reference to the following drawings and the detailed description of preferred embodiments.

The embodiment of the invention is shown in the drawings, in which:

Fig. 1 illustrates embodiment of the invention being used to image a patient's pelvic region; and

Fig. 2 illustrates the construction of the embodiment; and

Fig. 3 is a schematic diagram of the conductor network in the embodiment.

In this description, only a pelvic examination has been illustrated. This is because such examinations are common and easy to illustrate. However, the invention is equally applicable (after the appropriate dimensional changes) to the examination of any other forked region of the body such as the armpit, the space between adjacent fingers or toes, or any other cleft region.

The embodiment of the invention includes a housing generally indicated by reference numeral 2. The housing 2 has a first region 4, a second region 6, and a third region 8. The first and second regions 4 and 6 are rectangular and parallel to each other; the third region 8 is preferably perpendicular to the first and second regions 4 and 6.

When examining the pelvic region generally indicated by reference numeral 10, the patient is placed around the housing 2 in such a manner that the patient's legs 14 straddle the third region 8 and the pelvic region 10 is located between the first and second regions 4 and 6. Thereafter, and · using the conductor network described below, the pelvic region 10 is exposed to an RF field for magnetic resonance imaging techniques. These are known to those skilled in the art.

The housing 2 contains a conductor network for RF which may be configured either as a coil or as a resonator. If the network is in a coil configuration it contains at least one singly-connected loop; if the network is in a resonator configuration, it contains two conductor segments which are electrically disconnected from each other.

In the embodiment the conductor network is in a coil configuration. In this example, the conductor network is formed by one conductor 16 of, e.g. copper wire, but other materials or forms can be used instead and there may be more than one conductor. The conductor 16 is connected in a singly-connected coil so that it is topologically equivalent to a ring. In this example, there is exactly one turn of wire, but this is not necessary and a multi-turn embodiment can also be used. Alternatively, there may be a plurality of singly-connected coils in parallel with each other.

The conductor 16 is arranged into a first region generally indicated by reference numeral 18, a second region generally indicated by reference numeral 20, and a third region generally indicated by reference numeral 22. The first and second regions 18 and 20 are rectangular, planar, parallel to each other, and preferably aligned with each other; the third region 22 extends between the first and second regions 18 and 20 and is preferably but not necessarily perpendicular to them.

The first region 18 of the conductor is placed within the first region 4 of the housing 2, the second region 20 of the conductor is placed inside the second region 6 of the housing 2, and the third region 22 of the conductor 16 is placed inside the third region 8 of the housing 21. With this arrangement, the first and second regions 18 and 20 can receive and propagate an RF field from and to the patient's pelvic region 10, for imaging it.

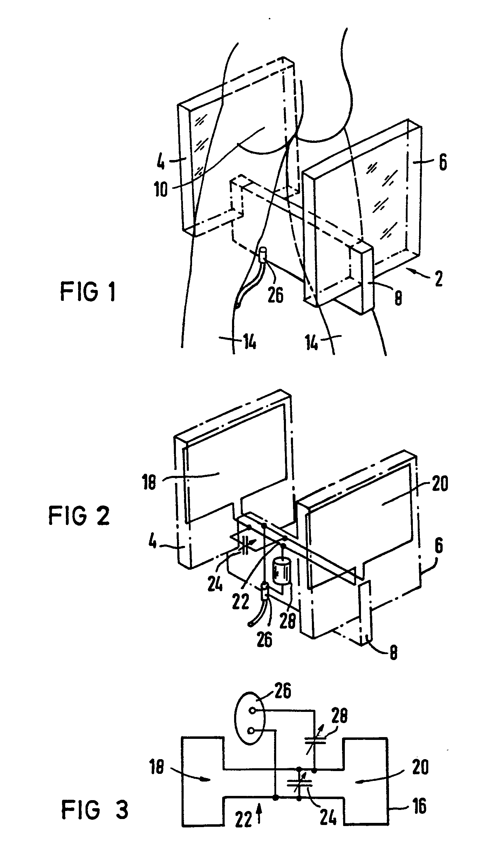

To create and receive such an RF field, the conductor 16 is here formed as an appropriately tuned circuit, which is illustrated schematically in Figure 3. As shown, the conductor 16 is bridged at approximately the middle of the third region 22 thereof by a variable capacitor 24. A coaxial cable connector 26 is likewise connected across the third region 22 of the conductor 16, in this instance through a variable capacitor 28 The capacitors 26 and 28 are used to match the impedance of the network and the conductor 16 to that of an RF source/receiver for a magnetic resonance imaging apparatus (not shown)l. The variable capacitors 24 and 28 may be connected in parallel with fixed capacitors. It is convenient if the capacitors 24 and 28 and the coaxial cable connector 26 are mounted to the third region 8 of the housing 2, but this is not required.

As long as a conductor network is usable as a magnetic resonance RF coil or resonator, it is appropriate for use in accordance with the invention.

The housing 2 is preferably oriented vertically, the patient being examined in a prone or supine position. This facilitates drawing the patient and the housing 2 into the magnetic field.

The housing 2 should not be of ferromagnetic material. This is because the housing 2 must be transparent to a magnetic field so that a uniform magnetic field is obtainable. The housing 2 may contain a Faraday shield surrounding certain regions of the conductor 16.

The housing 2 is preferably designed so that the first and second regions 4 and 6 are spaced apart such that e.g. the pelvis will fit between them without unnecessary looseness. Ideally, the housing 2 is just wide enough for a patient to fit into it, but this ideal is not usually realizable because the housing 2 must be used for patients of varying dimensions.

Those skilled in the art will understand that changes can be made in the embodiment here described, and that the embodiment can be used for other purposes. Such changes and uses are within the scope of the invention, which is limited only by the claims which follow.

## Claims

1. A device for use with magnetic resonance imaging equipment for imaging parts of a body forming an angle therebetween, comprising:
an electrical conductor network (16) for RF arranged in first, (4) second (6) and third (8) regions in a manner that the first (4) and second (6) regions are planar and parallel to each other and the third (8) region extends between the first and second regions, wherein the third (8) region is insertable in the angle between said parts of the body and the first (4) and second (6) regions receive and propagate an RF field suitable for magnetic imaging equipment;
and a housing (2) enclosing said network (16).

2. The device of claim 1, wherein said network (16) contains at least one electrically conductive loop.

3. The device of claim 1, wherein said network (16) includes a first capacitor (24).

4. The device of claim 3, further comprising a second capacitor (28) connected at one end to said network (16) and at another end to a terminal (26).

## Patentansprüche

1. Anordnung zur Verwendung in einem Gerät zur Bildgebung mittels kernmagnetischer Resonanz zur Abbildung von Körperteilen, die einen Winkel einschließen, enthaltend:
Ein Netzwerk (16) aus elektrischen Leitern für Hochfrequenz, das in ersten (4), zweiten (6) und dritten (8) Bereichen in der Weise angeordnet ist, daß der erste (4) und der zweite (6) Bereich eben und parallel zueinander angeordnet sind und daß sich der dritte Bereich (8) zwischen dem ersten und dem zweiten Bereich erstreckt, wobei der dritte Bereich (8) in den Winkel zwischen den genannten Körperteilen einfügbar ist und wobei der erste (4) und der zweite (6) Bereich ein Hochfrequenzfeld empfangen und ausbreiten, das für die Einrichtung zur magnetischen Bildgebung geeignet ist und ein Gehäuse (2), daß das genannte Netzwerk (16) enthält.

2. Anordnung nach Anspruch 1, wobei das genannte Netzwerk (16) zumindest eine elektrisch leitende Schleife enthält.

3. Anordnung nach Anspruch 1, wobei das genannte Netzwerk (16) einen ersten Kondensator (24) enthält.

4. Anordnung nach Anspruch 3, ferner enthaltend einen zweiten Kondensator (28), der mit einem Ende mit dem Netzwerk (16) und mit dem anderen Ende mit einem Anschluß (26) verbunden ist.

## Revendications

1. Un dispositif prévu pour l'utilisation avec un équipement d'imagerie par résonance magnétique, pour former des images de parties d'un corps qui forment un angle entre elles, comprenant:
un réseau de conducteurs électriques (16) prévu pour fonctionner en RF, disposé dans des première (4), seconde (6) et troisième (8) régions, d'une manière telle que les première (4) et seconde (6) régions soient planes et mutuellement parallèles, et que la troisième région (8) s'étende entre les première et seconde régions, avec une configuration dans laquelle la troisième région (8) peut être introduite dans l'angle entre les parties du corps précitées, et les première (4) et seconde (6) régions reçoivent et émettent un champ RF qui convient pour l'équipement d'imagerie magnétique; et une enceinte (2) dans laquelle le réseau (16) est enfermé.

2. Le dispositif de la revendication 1, dans lequel le réseau (16) contient au moins une boucle conductrice de l'électricité.

3. Le dispositif de la revendication 1, dans lequel le réseau (16) comprend un premier condensateur (24).

4. Le dispositif de la revendication 3, comprenant en outre un second condensateur (28) dont une armature est connectée au réseau (16) et dont l'autre armature est connectée à une borne (26).

FIG 1

4
10

6

26
2
8

14
14

FIG 2

18
20

4
6

24
22
28
26
8

FIG 3

26
28

18
20
16

22
24